# EUROPEAN PATENT APPLICATION

(11) **EP 4 683 068 A1**
(43) Date of publication of application: **21.01.2026**
(21) Application number: 24774503.7
(22) Date of filing: 13.02.2024
(51) Int. Cl.: H01M 50/227, H01M 50/213, H01M 50/256, H05K 5/00

(54) **ELECTRIC APPARATUS TO WHICH LABEL IS ADHERED**

(30) Priority: 17.03.2023 JP 2023043391
(71) Applicant: Panasonic Energy Co., Ltd., Moriguchi-shi, Osaka 570-8511 (JP)
(72) Inventor: SUZUKI Shinji, Osaka 571-0057 (JP); TAKATSUJI Yuki, Osaka 571-0057 (JP)
(74) Representative: Eisenführ Speiser
(86) International application number: PCT/JP2024/004787
(87) International publication number: WO 2024/195357

(57) **Abstract**

Provided is an electrical device with improved appearance of a label adhered to an outer case. The electrical device includes an outer case 2 made of resin, a label 4 adhered to an adhesion region 3 provided on a surface of the outer case 2, and a heat-generating member 5 stored in the outer case 2. The adhesion region 3 includes a plurality of grooves 31 extending in one direction.

## Description

### TECHNICAL FIELD

The present disclosure relates to an electrical device with a label adhered to an outer case.

### BACKGROUND ART

Battery packs containing secondary batteries, which can be repeatedly charged and discharged, are conveniently used as a power supply for various electrical products. In these battery packs, secondary batteries are stored in a resin-made outer case according to applications of the battery packs. Such battery packs are used as a power supply for portable electrical products, including, for example, digital cameras, video cameras, radios, power tools, and electric cleaners, as well as for assist bicycles, electric bikes, electric carts, and the like.

In these battery packs, a label is adhered to the surface of the battery pack to clearly indicate necessary printed information, such as voltage and capacity. Such a label is usually adhered to the surface of the outer case via an adhesive layer provided on one side thereof. However, due to the repeated charging and discharging, the temperature of the secondary batteries stored in the battery pack may increase and generate heat. When the resin outer case is heated to a high temperature due to, for example, the temperature rise of the secondary batteries inside, an outgas may be generated from the resin case. In such cases, the outgas generated from the resin case may remain as air bubbles between the case and the label, resulting in poor appearance.

Moreover, such adverse effects are not limited to battery packs but can also occur in any electrical devices containing heat-generating members stored in a resin case. For example, also in electrical devices such as chargers and power supply adapters that contain semiconductor elements or transformers inside, the temperature may rise and heat may be generated during the use. In such cases, if outgas is generated from the resin case, the generated outgas may remain as air bubbles between the case and the label, resulting in poor appearance.

### CITATION LIST

### PATENT LITERATURE

Patent Literature 1: Japanese Unexamined Patent Application Publication No. 2012-109050
Patent Literature 2: Japanese Unexamined Patent Application Publication No. 2010-108625
Patent Literature 3: Japanese Unexamined Patent Application Publication No. 2021-044888

### SUMMARY OF INVENTION

### TECHNICAL PROBLEM

One of the objects of the present disclosure is to provide an electrical device with improved appearance of a label adhered to an outer case.

### SOLUTION TO PROBLEM

An electrical device according to one embodiment of the present disclosure includes an outer case made of resin, a label adhered to an adhesion region provided on a surface of the outer case, and a heat-generating member stored in the outer case. The adhesion region includes a plurality of grooves extending in one direction.

### ADVANTAGEOUS EFFECTS OF INVENTION

The electrical device of the present disclosure makes it possible to provide an electrical device with improved appearance of the label adhered to the outer case.

### BRIEF DESCRIPTION OF DRAWINGS

FIG. 1 is a perspective view of an example of a battery pack as an electrical device according to Embodiment 1;
FIG. 2 is a partially enlarged exploded perspective view showing the battery pack of FIG. 1 with the label removed;
FIG. 3 is a cross-sectional view taken along line III-III of the battery pack of FIG. 1;
FIG. 4 is a cross-sectional view taken along line IV-IV of the battery pack of FIG. 1;
FIG. 5 is an enlarged cross-sectional view of a main part of the battery pack of FIG. 3;
FIG. 6 is a partially enlarged perspective view of another example of a battery pack as an electrical device according to Embodiment 2;
FIG. 7 is a partially enlarged exploded perspective view of an example of a charger with the label removed as an electrical device according to Embodiment 3;
FIG. 8 is a partially enlarged exploded perspective view of another example of a charger with the label removed as an electrical device according to Embodiment 4;
FIG. 9 is a partially enlarged exploded perspective view of another example of an electric tool with the label removed as an electrical device according to Embodiment 5;
FIG. 10 is a partially enlarged perspective view of an example of a conventional label;
FIG. 11 is a partially enlarged perspective view of an outer case according to Comparative Example 1; and
FIG. 12 is a partially enlarged perspective view of an outer case according to Comparative Example 2.

### DESCRIPTION OF EMBODIMENTS

In the following, one point of focus in the present disclosure is described. When a heat-generating member, such as a secondary battery stored in an outer case, generates heat during use of an electrical device, the resin outer case may be heated, thereby generating outgas from the outer case. At this time, if a label is adhered to the surface of the outer case, the generated gas may be accumulated between the surface of the outer case and the label, thereby forming air bubbles. Since the air bubbles thus formed inside the label deteriorate the appearance, measures to prevent the occurrence of such air bubbles have been considered.

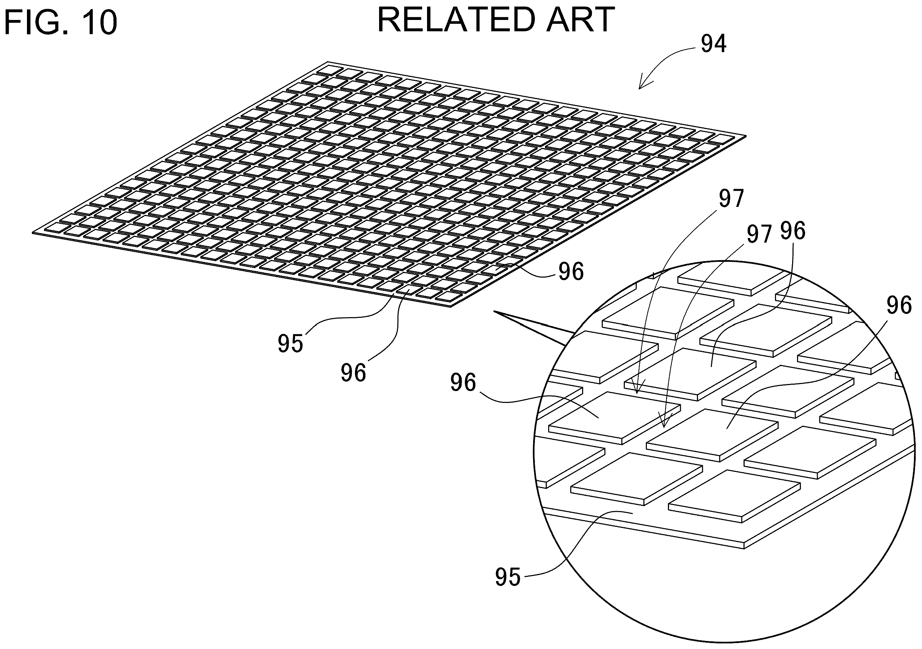

FIG. 10 is a partially enlarged perspective view of an example of a label 94 that has been devised to eliminate such adverse effects. The label 94 shown in the figure includes an adhesive layer 96 that is to be provided on one side of a base sheet 95. This adhesive layer 96 includes a large number of adhesive blocks 96 arranged in a matrix. Each of the adhesive blocks 96 shown in the figure has a square shape in plan view, and gaps 97 are provided in a grid pattern between the adhesive blocks 96 arranged in matrix. This structure of the label 94 allows the outgas generated from the resin case to pass through the gaps 97 provided between the adhesive blocks 96 and be exhausted, in a state where the face of the label 94 having the adhesive layer 96 is adhered to the surface of the outer case. However, according to this structure of the label 94, if the gaps 97 formed between the adhesive blocks 96 are crushed, the generated outgas cannot be exhausted, and the gas remains inside the label 94, thereby causing a problem of generating air bubbles.

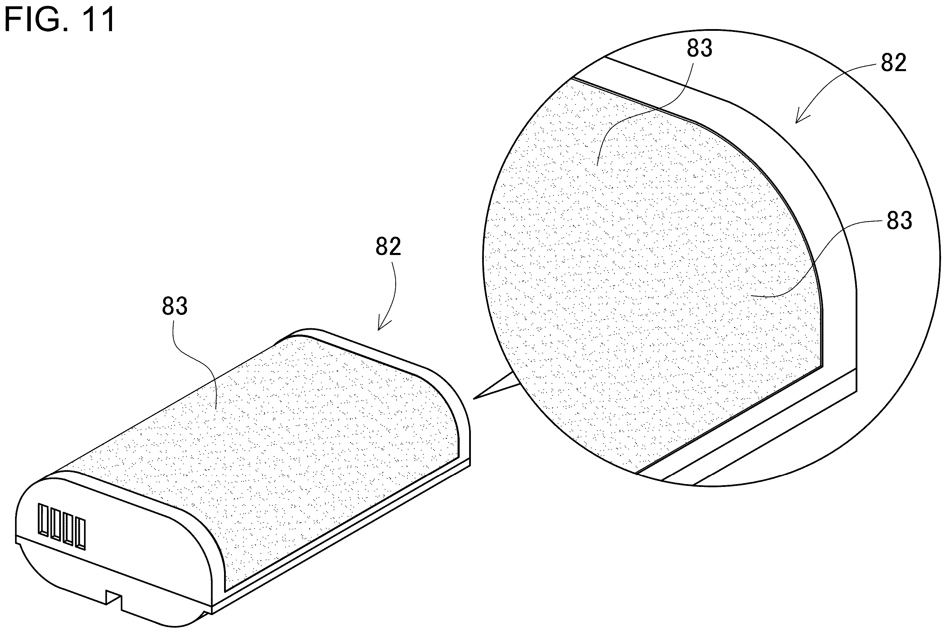

In view of the problems described above, the present inventors have considered a structure capable of exhausting the outgas generated on the rear side of the label by changing the surface state of the outer case rather than the label. The present inventors have attempted to exhaust the outgas to outside and prevent the generation of air bubbles by applying texturing, by which fine protrusions and depressions are provided, to the surface of the outer case, as shown in an outer case 82 of Comparative Example 1 shown in FIG. 11. However, in this structure, when the label is adhered, an adhesive of the label may enter between fine texturing patterns 83, blocking the fine protrusions and depressions, thereby causing insufficient exhaustion of gas.

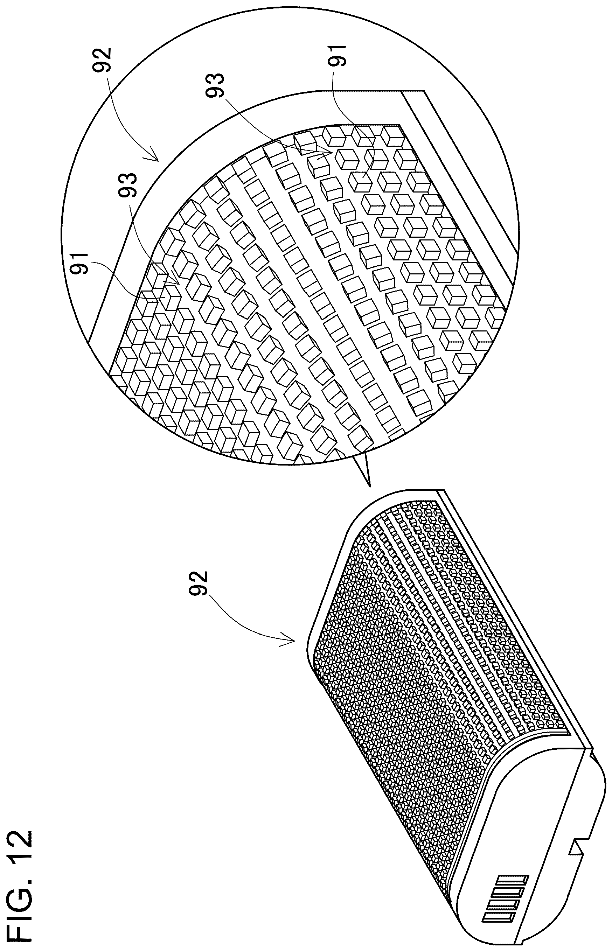

Therefore, the present inventors have produced a prototype, which is an outer case 92 of Comparative Example 2 shown in FIG. 12. This outer case 92 includes a large number of grooves 91 in a grid pattern on the surface of the case. The outer case 92 shown in the figure includes the grooves 91 in a grid pattern on the surface of the case, thereby forming surface blocks 93 having a rectangular shape in plan view and sectioned by the vertical and horizontal grooves 91. A label is adhered to the upper face of the surface blocks 93. In this case, the generated gas was efficiently moved through the grooves 91 in a grid pattern provided on the surface of the outer case 92, which could effectively prevent the occurrence of air bubbles. However, a mark of the shape of the depressed grooves of the case is visible on the surface of the thin label, resulting in a drawback of poor appearance.

In view of such circumstances, the present inventors have conceived of a structure having particular shapes of protrusions and depressions in the adhesion region provided on the surface of the outer case. This structure allows for reliable elimination of the outgas generated from the resin case, thereby reliably preventing generation of air bubbles, thus improving the appearance of the label adhered to the surface of the outer case. This structure is described in detail below.

To solve the problems described above, an electrical device according to one embodiment of the present disclosure includes an outer case made of resin, a label adhered to an adhesion region provided on a surface of the outer case, and a heat-generating member stored in the outer case. The adhesion region includes a plurality of grooves extending in one direction.

In the electrical device described above, even if outgas is generated from the resin in the adhesion region where the label is adhered, the generated gas is guided to the grooves provided in the adhesion region, thereby effectively preventing the occurrence of residual gas and air bubbles between the surface of the case and the label. This can prevent a situation of deteriorating appearance of the label adhesion portion. Further, since a plurality of grooves extending in one direction are provided in the adhesion region, the label can be neatly adhered along the surface of the outer case while avoiding a decrease in the visibility of the label. Furthermore, during the manufacturing of the electrical devices, there is also a characteristic of preventing air bubbles generated by air entering between the surface of the case and the label during the process of adhering the label to the outer case, thereby allowing the improved appearance of the label in the initial adhesion state.

In this specification, "outgas" refers to a gas generated from a resin case when the resin case is heated, that is, a gas vaporized by heating resin components, moisture contained in the resin, or moisture permeated into the case, and means various gases including water vapor and the like.

The electrical device of the present disclosure may also be specified by, but not limited to, the following configurations and features. A power supply device according to another embodiment of the present disclosure is as recited in the preceding embodiment, wherein the surface of the outer case includes a curved face, and the adhesion region includes the curved face. With this configuration, the adhesion region can be provided over a wider range of the outer case, thereby increasing the area of the label to be adhered. Moreover, the appearance can be improved by adhering the label along the curved face.

An electrical device according to another embodiment of the present disclosure may be as recited in the preceding embodiment, wherein the plurality of grooves formed on the curved face are grooves orthogonal to an extension direction of the outer case in plan view. This configuration enables easy demolding and reduction of mold cost while providing grooves on the curved face.

An electrical device according to another embodiment of the present disclosure is as recited in any one of the preceding embodiments, wherein the outer case has a box-like shape or a tube-like shape extending in a longitudinal direction, and the plurality of grooves extend in a direction intersecting the longitudinal direction. With this configuration in which the grooves intersecting the longitudinal direction of the outer case are provided, it is possible to shorten the total length of each groove and shorten the exhaustion path to ensure effective gas exhaustion.

An electrical device according to another embodiment of the present disclosure is as recited in any one of the preceding embodiments, wherein the adhesion region has a rectangular shape in plan view, and the plurality of grooves are obliquely inclined relative to sides of the adhesion region having a rectangular shape. This configuration can easily avoid a situation in which the edge portion of the label is lifted within the groove and becomes prone to peeling.

An electrical device according to another embodiment of the present disclosure is as recited in any one of the preceding embodiments, wherein the outer case is in the form of a box in which side walls are coupled to both sides of a surface plate having a flat face and end face walls are coupled to both ends of the surface plate, a boundary between the surface plate and each side wall forms a curved portion, and an adhesion region is provided from the surface plate across to each of the side walls. With this configuration in which the adhesion region is provided across the adjacent faces of the outer case, the adhesion region is made wider, thereby increasing the area of the label to be adhered. In particular, by providing the boundary between the adjacent faces as a curved face, the label can be adhered along the surface of the outer case without difficulty.

An electrical device according to another embodiment of the present disclosure is as recited in the preceding embodiment, wherein the outer case includes the plurality of grooves extending from the surface plate across to each of the side walls. With this configuration in which the grooves extending across the adjacent faces are provided, gases generated in the inner face side of the label can be also flowed to the adjacent face side through continuous grooves and exhausted.

An electrical device according to another embodiment of the present disclosure is as recited in any one of the preceding embodiments, wherein an edge of each of the grooves is opened from an outer peripheral edge of the label. With this configuration, by opening the edge of the groove from the outer peripheral edge of the label, gas flowing inside the groove can be efficiently exhausted from the open portion to the outside.

An electrical device according to another embodiment of the present disclosure may be as recited in any one of the preceding embodiments, wherein each of the grooves has a depth (d) of 0.05 mm to 0.2 mm.

An electrical device according to another embodiment of the present disclosure may be as recited in any one of the preceding embodiments, wherein each of the grooves has an opening width (W) of 0.1 mm to 0.5 mm, and a width (H) of a protruded face having protrusions and depressions in cross-sectional view and forming the plurality of grooves is 0.1 mm to 0.5 mm.

An electrical device according to another embodiment of the present disclosure is as recited in any one of the preceding embodiments, wherein the heat-generating member is a secondary battery, and the label displays information regarding the secondary battery. Further, an electrical device according to another embodiment of the present disclosure is as recited in the preceding embodiment, wherein the electrical device is a battery pack.

An electrical device according to another embodiment of the present disclosure is as recited in any one of the preceding embodiments, wherein the heat-generating member is a semiconductor device or a transformer, and the electrical device is a charger or a power supply adapter.

Embodiments of the present disclosure are described below with reference to the drawings. However, the embodiments shown below are only examples to illustrate the technical concepts of the present disclosure, and the present disclosure is not limited to these embodiments. Further, this specification does not limit any member in the claims to the members described in the embodiments. In particular, the dimensions, materials, shapes, relative positions, etc. of the components described in these embodiments are not intended to limit the scope of the present disclosure unless particularly otherwise specified, and are merely illustrative. It should be noted that the sizes, positional relationships, etc. of the members shown in the drawings may be exaggerated for clarity in the description. Furthermore, in the following description, the same names and reference numbers indicate the same or similar members, and detailed descriptions are omitted as appropriate. Furthermore, each element constituting the present disclosure may have an aspect in which a plurality of elements is formed from the same member and a single member serves as a plurality of elements; conversely, a function of a single member can also be implemented by being shared among a plurality of members.

The electrical device of the present disclosure is an electrical device storing a heat-generating member in a resin outer case, with a label adhered to the adhesion region provided on the outer case. In this specification, the heat-generating member refers to a member that generates heat during its use, including secondary batteries that generate heat during charging and discharging, semiconductor elements, transformers, and the like. Therefore, examples of electrical devices of the present disclosure include battery packs storing secondary batteries in an outer case, chargers storing semiconductor elements, transformers, and the like in an outer case, and power supply adapters. However, in the present disclosure, the heat-generating member is not limited to secondary batteries, semiconductor elements, and transformers, and examples of heat-generating members may also include loads such as motors, heaters, bulbs, light-emitting elements, and the like. Therefore, examples of the electrical devices of the present disclosure may also include, in addition to battery packs, chargers, and power supply adapters, power tools storing motors inside, electric toothbrushes and electric shavers with motors and secondary batteries, electric warmers and electric heating pads with heaters, lighting devices with bulbs and light-emitting elements, and the like. In the following, a battery pack is described as Embodiments 1 and 2 of the electrical device according to the present disclosure, a charger is described as Embodiments 3 and 4 of the electrical device according to the present disclosure, and an electric tool is described as Embodiment 5 of the electrical device according to the present disclosure.

### [EMBODIMENT 1]

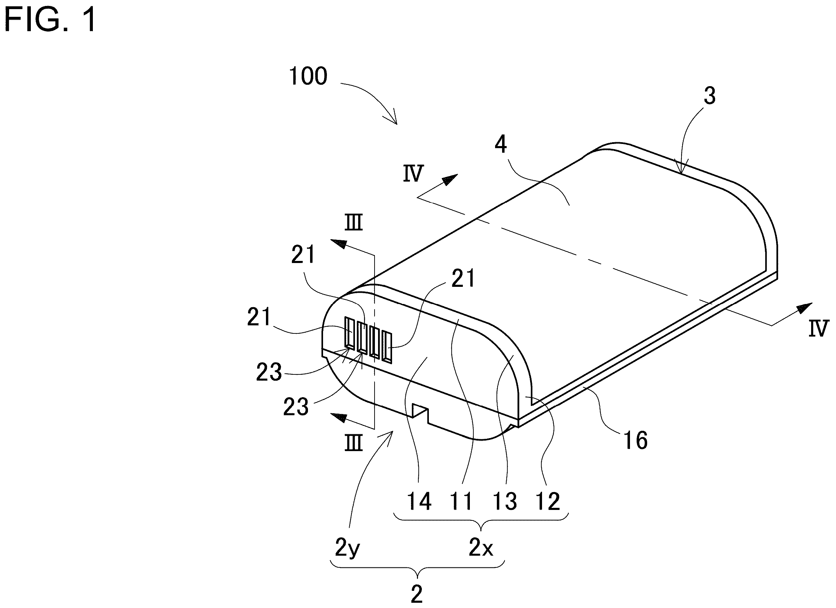

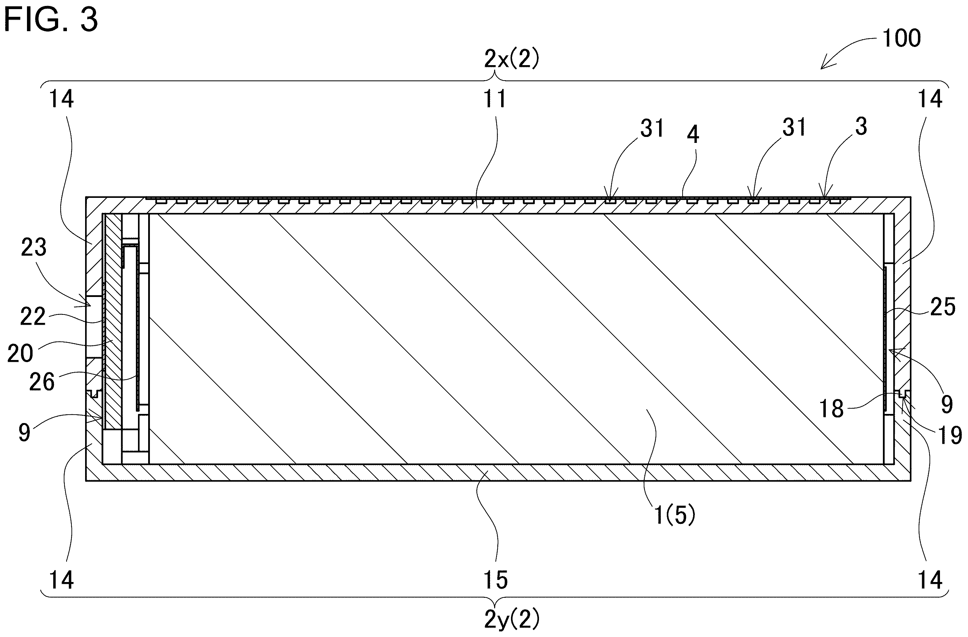

FIGs. 1 to 4 illustrate a battery pack 100 as an electrical device according to Embodiment 1. The battery pack 100 shown in the figure stores secondary batteries 1 as heat-generating members 5 inside an outer case 2. The secondary batteries 1 may generate heat during repeated charging and discharging. Therefore, in the battery pack 100 storing the secondary batteries 1 inside, each secondary battery 1 corresponds to the heat-generating member 5.

### (Secondary Battery 1)

The battery pack 100 shown in the figure stores, as the secondary batteries 1, two cylindrical batteries 1A arranged in parallel in two rows in the outer case 2. The charging and discharging capacity of the battery pack 100 is adjustable by the number of cylindrical batteries 1 stored in the outer case 2. Therefore, the battery pack 100 stores as many secondary batteries 1 as needed to achieve a capacity optimal for its intended use.

Each secondary battery 1 is a lithium-ion secondary battery. A lithium-ion secondary battery has a large charging and discharging capacity relative to its volume and weight. This allows the battery pack 100 to have a small outer shape and to be lightweighted while ensuring a large charging and discharging capacity. However, the battery pack of the present disclosure may also employ any other batteries that can be charged and discharged, instead of lithium-ion secondary batteries. Furthermore, although the battery pack shown in the figure stores the cylindrical batteries 1A as the secondary batteries 1, prismatic batteries or laminated batteries may also be used as the secondary batteries 1.

### (Outer Case 2)

The outer case 2 is made of resin. The outer case has a label 4 adhered to an adhesion region 3 provided on the surface. The resin used for the outer case 2 is a thermoplastic resin, preferably a flame-retardant resin. For example, polycarbonate can be used as such a resin. However, other resins can also be used for the resin.

The outer case 2 includes a storage space for storing the secondary batteries 1 inside. The outer shape of the outer case 2 is formed into a box as a whole, allowing the outer case 2 to store the secondary batteries 1 and other electronic components inside. The outer case 2 in the form of a box may be formed into a rectangular prism as a whole. However, the outer case 2 may also have a structure with a curved face according to the size and shape of the secondary batteries 1 and other various built-in components. The outer case 2 shown in FIGs. 1 to 4 has a box-like shape extending in the longitudinal direction and also has a shape extending in the axial direction of the cylindrical batteries 1A stored inside.

The outer case 2 shown in FIGs. 1 to 4 includes a first case 2x and a second case 2y, which are separately molded from resin. The outer case 2 shown in the figure has a structure in which the first case 2x and the second case 2y are each formed into a box with a bottom and are coupled to each other at their opposing opening edges to store the secondary batteries 1 and a circuit board 20 inside. The opposing opening edges of the first case 2x and the second case 2y are secured by ultrasonic welding. In the battery pack 100 shown in the figure, the upper case in the figure serves as the first case 2x and the lower case serves as the second case 2y. In the outer case 2 shown in FIGs. 1 to 3, the first case 2x is molded to have a depth greater than the depth of the second case 2y, and the adhesion region 3 is provided on the surface of the first case 2x, which is wider than that of the second case 2y.

### (First Case 2x)

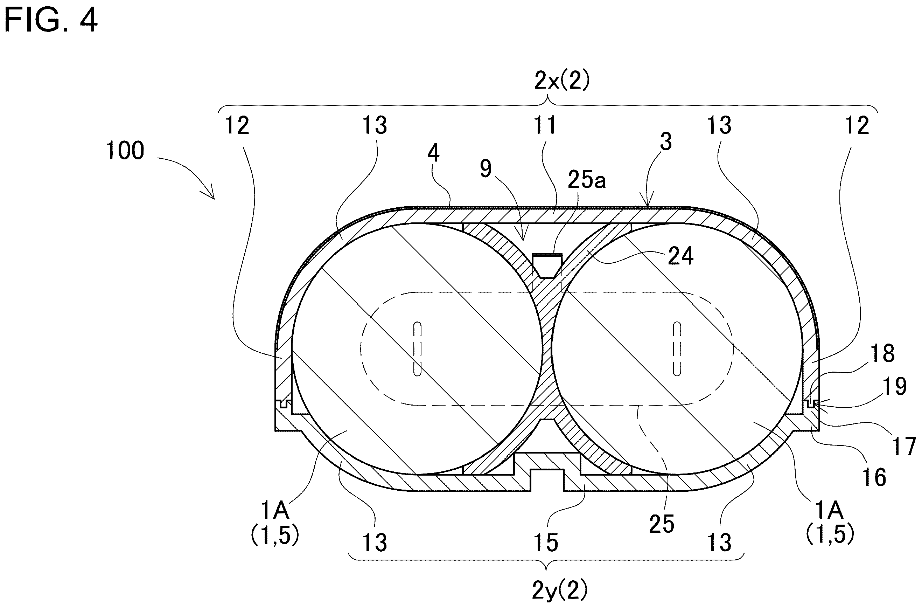

The first case 2x has side walls 12 on both sides of a surface plate 11 having a flat face, with curved portions 13 provided at the boundary between the surface plate 11 and each side wall 12. Further, the first case 2x is integrally molded into a box by coupling end face walls 14 in a vertical orientation to both ends of the surface plate 11, the side walls 12, and the curved portions 13. The first case 2x shown in the figure has the curved portions 13 that curve along the outer peripheral faces of the cylindrical batteries 1A stored therein. The first case 2x shown in FIG. 4 has such a shape that the curved portions 13 covers a region of about 1/4 of the outer periphery of the cylindrical batteries 1A, with the surface plate 11 having a flat face extending in the horizontal direction and the side walls 12 being in a vertical orientation. In this first case 2x, the side walls 12 on both sides and the end face walls 14 on both ends form a peripheral wall which is rectangular in bottom view. The first case 2x is coupled to the second case 2y via the end face of the peripheral wall that serves as a coupling face. The side walls 12 and the end face walls 14 are provided with welding ribs 18 protruding from the tip end face, which are secured to the opposing face of the second case 2y by ultrasonic welding.

### (Second Case 2y)

The second case 2y is integrally molded into a shallow box, which contains a surface plate 15 having a flat face, curved portions 13 coupled to both sides of the surface plate 15, and end face walls 14 coupled to the both ends of the surface plate 15 and the curved portions 13 in a vertical orientation. Further, as shown in FIG. 4, the second case 2y includes horizontal portions 16, to which the ultrasonic horn is pressed, along the both side edges of the curved portions 13 on both sides. The second case 2y includes welding grooves 19, each of which guides each welding rib 18 of the first case 2x to the tip end face of a coupling wall 17 and the end face wall 14 provided on the horizontal portion 16.

### (Adhesion Region 3)

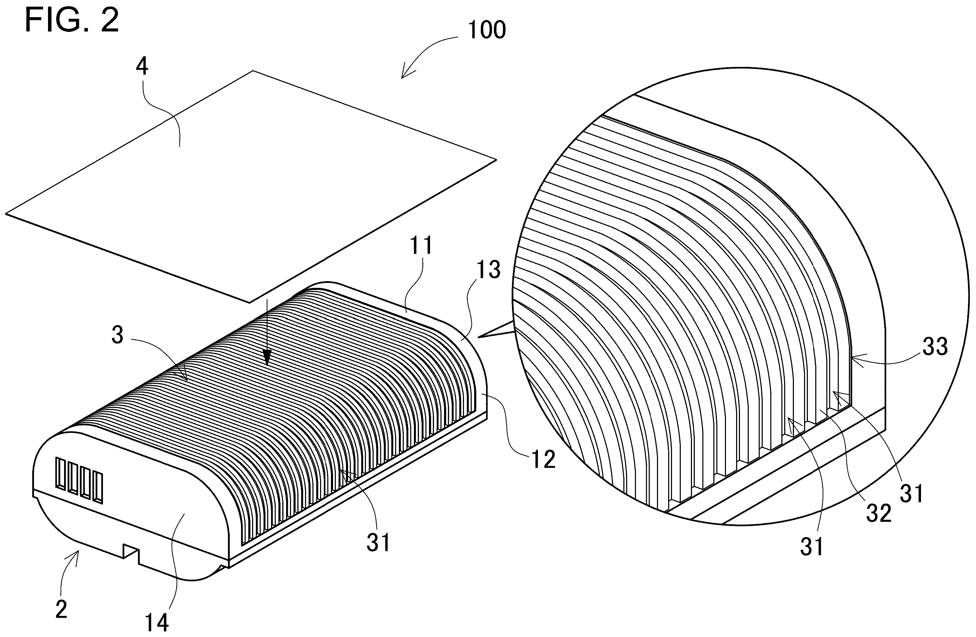

The outer case 2 includes, on its surface, an adhesion region 3 to which the label 4 is adhered. The outer case 2 shown in FIG. 2 includes the adhesion region 3 on the surface of the first case 2x. The adhesion region 3 shown in FIG. 2 extends from the surface plate 11 of the first case 2x across to the side walls 12, allowing the label 4 to be adhered over a wider area of the outer case 2. As described above, the structure in which the adhesion region 3 extends from the surface plate 11 having a flat face to the side walls 12 via the curved faces 13 has a characteristic of adhering the label 4 from the surface plate 11 to the side walls 12 while curving the label 4 along the curved portions 13, thereby improving the appearance. In the outer case 2 shown in the figure, the adhesion region 3 is provided over approximately the entire part of the surface plate 11, the curved portions 13, and the side walls 12, which extend in the longitudinal direction. However, the adhesion region may also be provided partially on the surface plate, the curved portions, and the side walls. Further, the adhesion region provided on the outer case may also be provided only on the surface plate, or on both the surface plate and the curved portions.

### (Grooves 31, Protruded Faces 32)

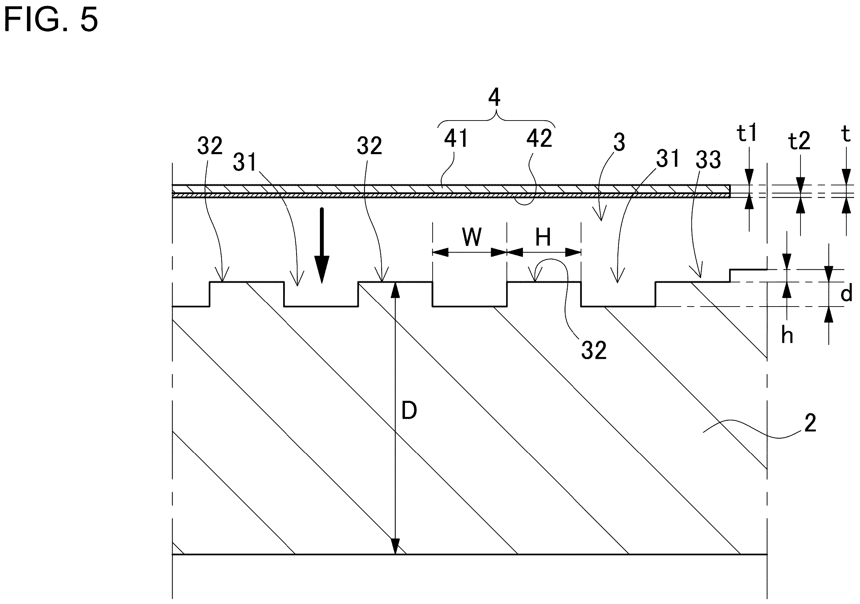

Further, the outer case 2 includes a plurality of grooves 31, which are disposed inside the label 4 adhered to the adhesion region 3 to allow the inflow of outgas generated from the outer case 2. By providing an air movement space in the rear side of the label 4, the plurality of grooves 31 prevent the outgas generated from the outer case 2 from remaining between the label 4 and the outer case 2, thereby preventing the formation of air bubbles inside the label 4. As shown in FIGs. 2 and 5, the outer case 2 includes a plurality of rows of the grooves 31 that are in parallel and at equal intervals in the adhesion region 3. In the adhesion region 3, protruded faces 32 having protrusions and depressions in horizontal cross-sectional view and forming the plurality of grooves 31 are formed between adjacent grooves 31. Each protruded face 32 has a band-like shape extending along the grooves 31, and has a smooth upper face. The plurality of rows of the protruded faces 32 are formed so that their upper faces are positioned on the same plane. Specifically, the plurality of rows of the protruded faces 32 formed on the surface plate 11 and the side walls 12 are formed to be positioned on the same flat plane, and the plurality of rows of the protruded faces 32 formed along the curved portions 13 are formed to be positioned on the curved plane along the curved portions 13.

The grooves 31 adjacent to each other are formed in parallel, and the protruded faces 32 extending along the grooves 31 with a predetermined width are formed between the adjacent grooves 31. These protruded faces 32 serve as a region where an adhesive layer 42 of the label 4 is adhered. As shown in FIGs. 2 and 5, by forming the protruded faces 32 extending in the groove direction between the plurality of rows of the grooves 31 that are formed in parallel, the surface of the label 4 has improved appearance in a state where the label 4 is adhered to the adhesion region 3. By thus adhering the label 4 onto the protruded faces 32 formed in stripes, the label 4 can be disposed in a state of being adhered along the extension direction of the protruded faces 32, so that the label 4 adhered over the plurality of protruded faces 32 can be adhered while being stretched with a good appearance. In contrast, as shown in Comparative Example 2 in FIG. 12, the structure in which a plurality of surface blocks 91 are provided in the adhesion region results in poor appearance, as the shapes of grooves 93 formed between the vertically arranged surface blocks 91 and grooves 93 formed between the horizontally arranged surface blocks 91 are visible on the label surface.

The outer case 2 shown in FIG. 2 has a box-like shape extending in the longitudinal direction, which is the axial direction of the secondary batteries 1 stored inside. The outer case 2 includes a plurality of grooves 31 extending in a direction intersecting the longitudinal direction. In particular, the plurality of grooves 31 shown in FIG. 2 extend in the short-side direction orthogonal to the longitudinal direction. In other words, the plurality of grooves 31 are provided while being in parallel to the two opposing sides of the adhesion region 3 having a rectangular shape in plan view, which are the two sides of the surface plate 11 on the side of the end face wall 14. The grooves 31 extending in the short-side direction orthogonal to the longitudinal direction, when formed from the curved portions 13 across to the side walls 12, intersect the longitudinal direction of the outer case 2, so that the total length of each groove 31 can be shortened to achieve effective exhaustion.

Further, in the outer case 2 shown in FIG. 2, the plurality of grooves 31 provided from the curved portions 13 across to the side walls 12 extend in a direction orthogonal to the longitudinal direction of the outer case 2 in plan view. Specifically, the grooves 31 formed from the curved portions 13 toward the side walls 12 are opened to be positioned within a vertical face orthogonal to the longitudinal direction of the outer case 2. This structure of opening the plurality of grooves 31 in this manner has a characteristic of facilitating demolding of the mold for forming the grooves 31 that are formed on the curved portions 13 and side walls 12. This is because the extending direction of the grooves 31 formed on the curved portions 13 and the side walls 12 is the up-down direction, so that the grooves can be molded while allowing easy demolding.

The outer case 2 shown in FIG. 2 includes the plurality of grooves 31 extending from the surface plate 11 across to the side walls 12. Specifically, the plurality of grooves 31 formed on the surface plate 11 are coupled to the grooves 31 formed on the curved portions 13 and further coupled to the grooves 31 formed on the side walls 12. This structure of the grooves 31 allows the outgas generated in the surface plate 11 to move to the grooves 31 provided on the side walls 12, thereby exhausting it from the edge of the label 4 to the outside. The outer case 2 shown in FIG. 2 has a structure in which the lower ends of the grooves 31 provided on the side walls 2 are opened to the outside, allowing the outgas having been moved through the grooves 31 to be exhausted to the outside from these opened portions. However, the ends of the plurality of grooves 31 do not necessarily need to be opened from the outer peripheral edge of the label 4, and the edge portions of the grooves 31 can be closed with the label. This structure stores the generated outgas inside the grooves 31 without exhausting it to the outside of the grooves 31, preventing deterioration of appearance of the label 4.

By forming the plurality of grooves 31 in parallel with each other, the outer case 2 shown in FIG. 2 allows the grooves 31 and the band-shaped protruded faces 32 formed between the grooves 31 to form alternating stripes. The plurality of grooves 31 are formed with uniform opening widths (W) as shown in FIGs. 2 and 5, and the protruded faces 32 formed between the grooves 31 are also formed with uniform widths (H). Here, the opening width (W) of each groove 31 may be 0.1 to 0.5 mm, preferably 0.2 to 0.4 mm, and the width (H) of each protruded face 32 formed between the grooves 31 may be 0.1 to 0.5 mm, preferably 0.2 to 0.4 mm. As shown in FIGs. 2 and 5, the structure of providing a plurality of grooves 31 in stripes adjusts the ratio of the width (H) of the protruded faces 32 to the opening width (W) of the grooves 31, so that the total volume of the grooves formed in the adhesion region 3 and the total area of the protruded faces 32 where the label 4 is adhered are adjusted to be optimal.

The grooves 31 shown in FIG. 5 have flat bottoms and widths almost equal to the opening widths (W) of the grooves 31. This structure in which the shape of the plurality of grooves 31 in horizontal cross-sectional view has protrusions and depressions in the form of rectangular waves has a characteristic of increasing the volume of the grooves 31, thereby reliably allowing inflow of the outgas generated from the resin. Further, although not shown in the figures, the plurality of grooves 31 formed in the adhesion region 3 can be formed into a shape that is gradually narrowed from the opening to the bottom. This shape of the grooves with protrusions and depressions in the form of trapezoidal waves in horizontal cross-sectional view allows the side surfaces of the grooves to be inclined surfaces, providing draft angles for the molding die. Additionally, the plurality of grooves may have U-shaped or V-shaped cross-sectional shapes.

By adjusting the depth (d) of the plurality of grooves 31 in addition to the opening width (W), the total volume of the grooves can be adjusted. The plurality of grooves 31 formed in the adhesion region 3 may have a depth (d) of 0.05 mm to 0.2 mm, preferably 0.06 mm to 0.14 mm. The depth (d) of the grooves 31 formed in the adhesion region 3 is also adjusted by the thickness (D) of the outer case 2. For example, the depth (d) of the grooves 31 can be 1/20 to 1/5 of the thickness (D) of the outer case 2.

By thus providing the plurality of grooves 31 in the adhesion region 3, in the rear side of the label 4, the outgas generated from the outer case 2 is guided to the grooves 31 without remaining on the rear side of the label 4, thereby preventing the formation of air bubbles. Here, the outgas guided to the grooves 31 flows to the edge portion of the grooves 31 and is exhausted to the outside from the edge portion opened at the peripheral edge of the label 4.

### (Label 4)

As shown in FIG. 5, the label 4 includes the adhesive layer 42 on one side of a base sheet 41. For example, a PET sheet material can be used as the base sheet 41. In the label shown in FIG. 5, the thickness (t1) of the base sheet 41 is 0.02 to 0.4 mm, the thickness (t2) of the adhesive layer 42 provided on the base sheet 41 is 0.02 to 0.05 mm, and the total thickness (t) of the label 4 is 0.04 to 0.45 mm. The label 4 displays information regarding the electrical device to be used, information regarding the secondary battery 1, and the like, on its surface.

### (Stepped Recess 33)

Further, the outer case 2 shown in FIG. 5 includes a stepped recess 33, which is one step lower from the outside of the adhesion region 3, so that the surface of the label 4 adhered to the adhesion region 3 and the surface of the outer case 2 in regions other than the adhesion region 3 are present on the same flat face. The stepped recess 3 has a shape that follows the outer peripheral edge of the label, and is preferably formed to have a level difference (h) equal to the thickness (t) of the label. With this structure in which the stepped recess 33 is provided in the adhesion region 3, the label 4 can be accurately adhered by positioning its outer peripheral edge along the stepped recess 33.

### (Battery Block 9)

The battery pack 100 stores a battery block 9 in which two cylindrical batteries 1A and the circuit board 20 are integrally coupled in the outer case 2. In the battery block 9, the two cylindrical batteries 1A are arranged in parallel with each other, and the circuit board 20 is coupled to a position facing the end faces of the cylindrical batteries 1A. In the battery block 9, the two cylindrical batteries 1A are arranged in opposite orientations, connecting one pair of end face electrodes with a lead plate 25 while connecting a connection lead 25a extending from the lead plate 25 to the circuit board 20. The other pair of end face electrodes is connected to the circuit board 20 via a lead plate 26, and the two cylindrical batteries 1A are connected in series and connected to the circuit board 20. The battery block 9 includes a battery holder 24 between the two cylindrical batteries 1A to insulate them from each other while coupling the two cylindrical batteries 1A in a fixed position. The battery block 9 is disposed inside the outer case 2, and positive and negative output terminals 21 and a signal terminal 22 secured to the circuit board 20 are exposed to the outside through electrode windows 23 provided in the outer case 2.

### (Electrode Window 23)

One of the end face walls 14 of the first case 2x includes electrode windows 23 for exposing the positive and negative output terminals 21 and the signal terminal 22. The circuit board 20 is provided inside the electrode windows 23. As shown in FIGs. 1 to 3, the circuit board 20 has the output terminals 21 and the signal terminal 22 at the positions of the electrode windows 23. The circuit board 20 is coupled to the battery holder 24 in which the cylindrical batteries 1A are disposed in a fixed position.

The battery holder 24 is molded from plastic to allow the two cylindrical batteries 1A to be disposed in a fixed position while insulating them from each other. In the battery holder 24 shown in FIG. 4, two side faces facing the cylindrical batteries 1A are curved, thereby allowing the two cylindrical batteries 1A to be disposed in a fixed position. The battery holder 24 holds the two cylindrical batteries 1A in a fixed position so that the two cylindrical batteries 1A are in parallel with each other while being in opposite orientations.

The battery holder 24 is assembled into the battery block 9 by disposing the circuit board 20 and the cylindrical batteries 1A in a fixed position. In the battery block 9 shown in FIG. 4, the two cylindrical batteries 1A are connected in series with the lead plate 25 while being connected to the circuit board 20, and are disposed in a fixed position of the battery holder 24. Further, on the side of the circuit board 20, the end face electrodes of the cylindrical batteries 1A are connected to the circuit board 20 via the lead plate 26.

### [EMBODIMENT 2]

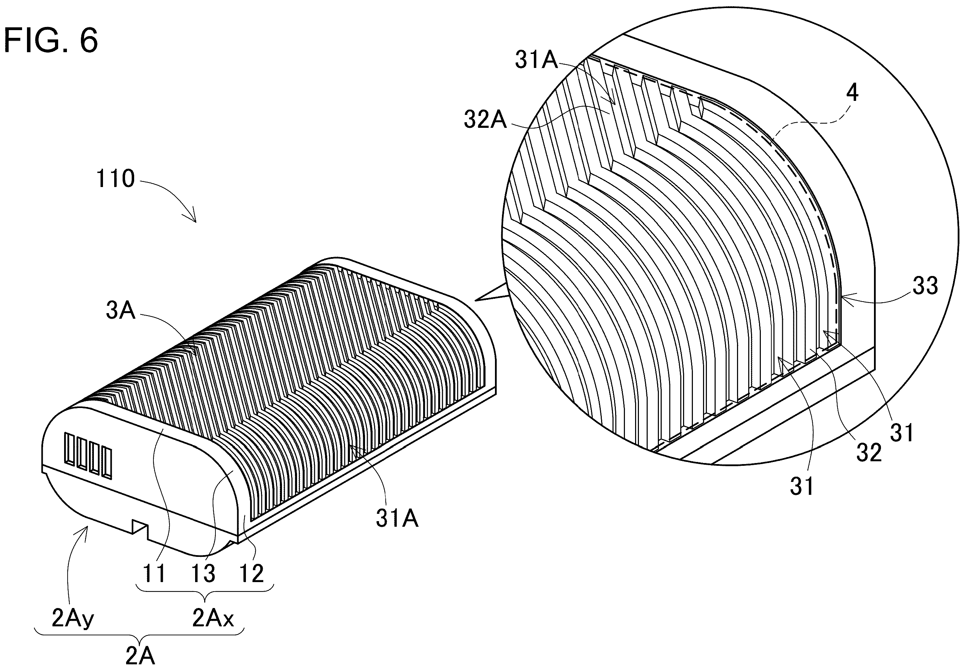

FIG. 6 illustrates a battery pack 110 having another structure as an electrical device according to Embodiment 2. The battery pack 110 shown in the figure includes, in the adhesion region 3A, grooves 31A and protruded faces 32A that have different shapes from those in the battery pack 100 of Embodiment 1 shown in FIGs. 1 to 4. Therefore, members other than these structures are given the same reference numbers as in Embodiment 1, and the detailed descriptions are omitted.

In an outer case 2A shown in FIG. 6, the extension directions of the plurality of rows of the grooves 31A formed on the surface plate 11 having a flat face and the protruded faces 32A formed between the grooves 31A are inclined relative to the sides of the adhesion region 3A having a rectangular shape in plan view. In the outer case 2A shown in FIG. 6, the inclination angle of the plurality of grooves 31A and the plurality of rows of protruded faces 32A are set to about 45 degrees relative to the sides of the adhesion region 3A. This structure in which the plurality of rows of grooves 31A are disposed in an inclined orientation relative to the side of the adhesion region 3A having a rectangular shape in plan view can effectively prevent a situation in which the edge portion of the label 4 is lifted between the grooves 31A and becomes prone to peeling.

The plurality of rows of the grooves 31 and the protruded faces 32 formed on the curved portions 13 and the side walls 12 coupled to both ends of the surface plate 11 are provided within a vertical face orthogonal to the longitudinal direction of the outer case 2, as in the outer case 2 described above. As shown in FIG. 6, at the boundary between the surface plate 11 and the curved portions 13, the grooves 31A in an inclined orientation formed on the surface plate 11 and the grooves 31 in an orthogonal orientation formed on the curved portions 13 are coupled with each other. Further, the protruded faces 32A in an inclined orientation in plan view formed on the surface plate 11 and the protruded faces 32 in an orthogonal orientation in plan view formed on the curved portions 13 are coupled with their surfaces continuous. With this configuration, even if outgas is generated at the surface plate 11, the outgas that has flowed into the grooves 31A formed in an inclined orientation in the surface plate 11 can be flowed into the grooves 31 of the side walls 12 via the grooves 31 formed on the curved portions 13.

The outer case 2A having the grooves 31, 31A and the protruded faces 32, 32A in such shapes also allows the grooves 31, 31A and the protruded faces 32, 32A, which extend from the surface plate 11 to the side walls 12 via the curved portions 13, to be molded with the demolding direction being the up-down direction in the figure, as in the outer case 2 described above, achieving a characteristic of low-cost mass production with a simplified mold structure.

### [EMBODIMENT 3]

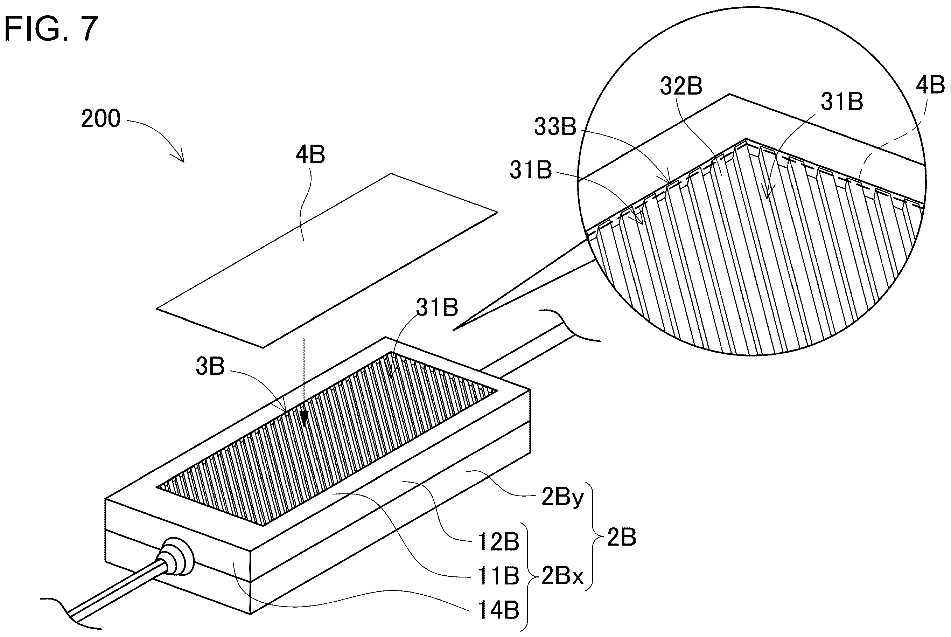

FIG. 7 illustrates an example of a charger 200 as an electrical device according to Embodiment 3. The charger 200 shown in the figure includes an outer case 2B having a rectangular-prism appearance with no curved portions. This outer case 2B is also divided into a first case 2Bx and a second case 2By. The first case 2Bx includes side walls 12B having a vertical orientation on both sides of a surface plate 11B, and end face walls 14B having a vertical orientation on both ends of the surface plate 11B and the side walls 12B.

The outer case 2B shown in FIG. 7 includes an adhesion region 3B for a label 4B only on the surface plate 11B of the first case 2Bx. A plurality of rows of grooves 31B formed on the surface plate 11B shown in FIG. 7 and protruded faces 32B formed between the grooves 31B extend in a direction inclined relative to the sides of an adhesion region 3B having a rectangular shape in plan view. Also in the outer case 2B shown in FIG. 7, the inclination angle of the plurality of grooves 31B and the plurality of rows of protruded faces 32B are set to about 45 degrees relative to the sides of the adhesion region 3B. This outer case 2B is also structured such that the label 4B is adhered only to the surface plate 11B having a flat face while disposing the plurality of rows of grooves 31A in an inclined orientation relative to the sides of the adhesion region 3B having a rectangular shape in plan view, allowing the edge portion of the label 4 to be reliably adhered to each stepped recess 33B. This can effectively prevent a situation in which the edge of the label 4 is lifted between the grooves and becomes prone to peeling.

### [EMBODIMENT 4]

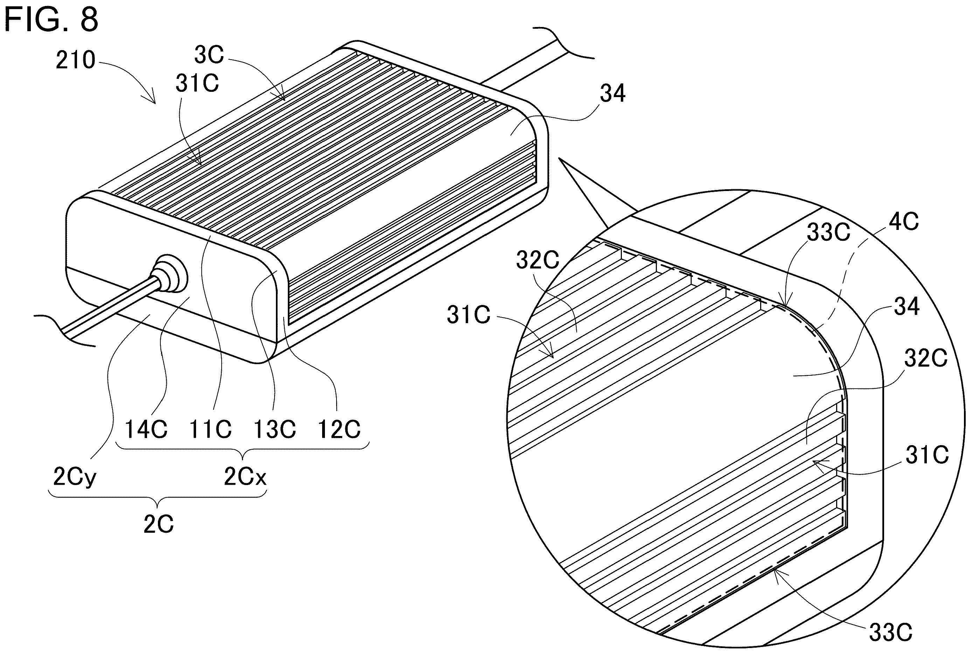

FIG. 8 illustrates another example, which is a charger 210, as an electrical device according to Embodiment 4. The charger 210 shown in the figure has an outer case 2C that is divided into a first case 2Cx and a second case 2Cy. The first case 2Cx has side walls 12C on both sides of a surface plate 11C having a flat face, and curved portions 13C at the boundaries between the surface plate 11C and the side walls 12C. Further, end face walls 14C in a vertical orientation are coupled to both ends of the surface plate 11C, the side walls 12C, and the curved portions 13C. With this configuration, the charger 210 is integrally molded into a box.

This outer case 2C includes an adhesion region 3C for a label 4C from the surface plate 11C across to the side walls 12C on both sides. This outer case includes a plurality of grooves 31C extending in the longitudinal direction and band-shaped protruded faces 32C formed between the grooves 31C on the surface plate 11C and the side walls 12C. In this outer case 2C, although the label 4C is adhered from the surface plate 11C across to the side walls 12C, no grooves are provided in curved portions 34 of the adhesion region 3C. With this structure of the outer case 2C in which the grooves 31C extending in the longitudinal direction are not provided in the curved portions 34, the mold can be simplified. This outer case 2C is structured such that the label 4C is adhered from the surface plate 11C having a flat face across to the side walls 12C while reliably adhering the middle and edge portions of the label 4 to each stepped recess 33C with a good appearance, thereby effectively preventing a situation in which the edge of the label 4 is lifted between the grooves 31C and becomes prone to peeling.

### [EMBODIMENT 5]

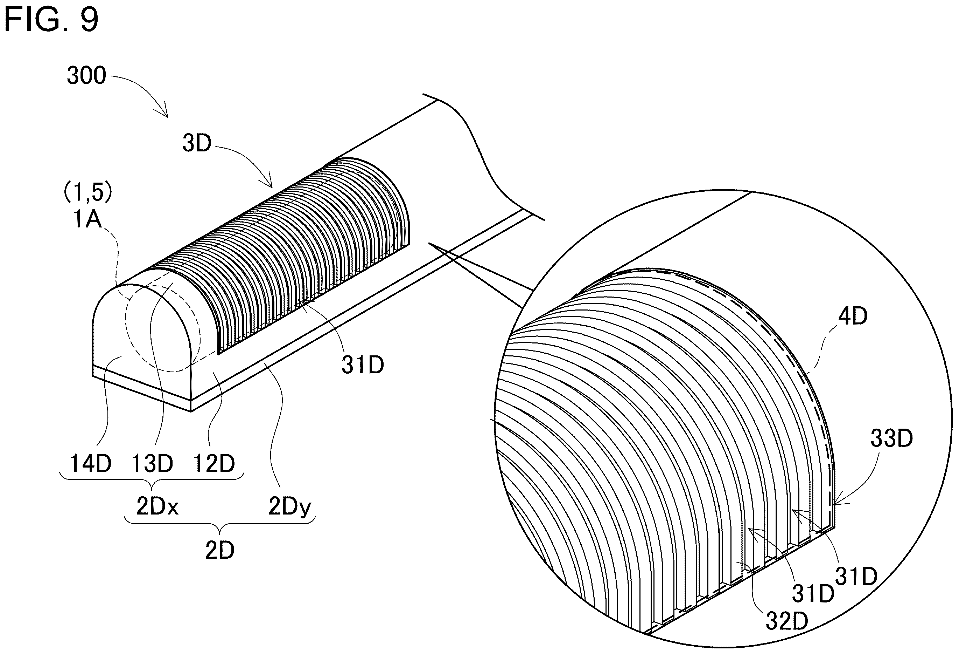

FIG. 9 illustrates an example of an electric tool 300 as an electrical device according to Embodiment 5. The electric tool 300 shown in the figure has an outer case 2D that is divided into a first case 2Dx and a second case 2Dy. The first case 2Dx has side walls 12D on both sides of curved portions 13D. Further, end face walls 14D in a vertical orientation are coupled to both ends of curved portions 11D and the side walls 12D. With this configuration, the electric tool 300 is integrally molded into a box.

This outer case 2D includes an adhesion region 3D for a label 4D across the side walls 12D on both sides of the curved portions 13D. This outer case 2D includes a plurality of grooves 31D orthogonal to the longitudinal direction and band-shaped protruded faces 32D formed between the grooves 31D on the curved portions 13D and the side walls 12D. The outer case 2D having the grooves 31D and the protruded faces 32D in such shapes also allows the grooves 31D and the protruded faces 32D, which extend from the curved portions 13D to the side walls 12D, to be molded with the demolding direction being the up-down direction in the figure, as in the outer case 2 described above, achieving a characteristic of low-cost mass production with a simplified mold structure. Further, it is also possible to reliably adhere the edge portion of the label 4 to each stepped recess 33D, thereby effectively preventing a situation in which the edge of the label 4 is lifted between the grooves 31D and becomes prone to peeling.

### INDUSTRIAL APPLICABILITY

The electrical device of the present disclosure refers to various electrical devices including heat-generating members in an outer case made of resin, which can be conveniently used for battery packs, chargers, power supply adapters, power tools, electric toothbrushes, electric shavers, electric warmers, electric heating pads, lighting devices, and the like.

### REFERENCE SIGNS LIST

100, 110 ... battery pack
200, 210 ... charger
300 ... electric tool
1 ... secondary battery
1A ... cylindrical battery
2, 2A, 2B, 2C, 2D ... outer case
2x, 2Ax, 2Bx, 2Cx, 2Dx ... first case
2y, 2Ay, 2By, 2Cy, 2Dy ... second case
3, 3A, 3B, 3C, 3D ... adhesion region
4, 4B, 4C, 4D ... label
5 ... heat-generating member
9 ... battery block
11, 11B, 11C ... surface plate
12, 12B, 12C, 12D ... side wall
13, 13C, 13D ... curved portion
14, 14B, 14C, 14D ... end face wall
15 ... surface plate
16 ... horizontal portion
17... coupling wall
18 ... welding rib
19 ... welding groove
20 ... circuit board
21 ... electrode terminal
22 ... signal terminal
23 ... electrode window
24 ... battery holder
25 ... lead plate
26 ... lead plate
31, 31A, 31B, 31C, 31D ... groove
32, 32A, 32B, 32C, 32D ... protruded face
33, 33B, 33C, 33D ... stepped recess
34 ... curved portion
41 ... base sheet
42 ... adhesive layer
82 ... outer case
83 ... texturing pattern
91... surface block
92 ... outer case
93 ... groove
94 ... label
95 ... base sheet
96 ... adhesive block
97 ... gap

## Claims

1. An electrical device comprising:
an outer case made of resin;
a label adhered to an adhesion region provided on a surface of the outer case; and
a heat-generating member stored in the outer case,
wherein the adhesion region includes a plurality of grooves extending in one direction.

2. The electrical device as recited in claim 1, wherein
the surface of the outer case includes a curved face, and
the adhesion region includes the curved face.

3. The electrical device as recited in claim 2, wherein the plurality of grooves formed on the curved face are grooves extending in a direction orthogonal to an extension direction of the outer case in plan view.

4. The electrical device as recited in claim 1, wherein
the outer case has a box-like shape or a tube-like shape extending in a longitudinal direction, and
the plurality of grooves extend in a direction intersecting the longitudinal direction.

5. The electrical device as recited in claim 1, wherein
the adhesion region has a rectangular shape in plan view, and
the plurality of grooves are obliquely inclined relative to sides of the adhesion region having a rectangular shape.

6. The electrical device as recited in claim 1, wherein
the outer case is in a form of a box in which side walls are coupled to both sides of a surface plate having a flat face and end face walls are coupled to both ends of the surface plate,
a boundary between the surface plate and each side wall forms a curved portion, and
the adhesion region is provided from the surface plate across to each of the side walls.

7. The electrical device as recited in claim 6, wherein the outer case includes the plurality of grooves extending from the surface plate across to each of the side walls.

8. The electrical device as recited in any one of claims 1 to 7, wherein an edge of each of the grooves is opened from an outer edge of the label.

9. The electrical device as recited in any one of claims 1 to 7, wherein each of the grooves has a depth (d) of 0.05 mm to 0.2 mm.

10. The electrical device as recited in any one of claims 1 to 7, wherein
each of the grooves has an opening width (w) of 0.1 mm to 0.5 mm, and
a width (h) of a protruded face having protrusions and depressions in cross-sectional view and forming the plurality of grooves is 0.1 mm to 0.5 mm.

11. The electrical device as recited in any one of claims 1 to 7, wherein
the heat-generating member is a secondary battery, and
the label displays information regarding the secondary battery.

12. The electrical device as recited in claim 11, wherein the electrical device is a battery pack.

13. The electrical device as recited in any one of claims 1 to 7, wherein
the heat-generating member is a semiconductor device or a transformer, and
the electrical device is a charger or a power supply adapter.
